# EUROPEAN PATENT APPLICATION

(11) **EP 4 339 414 A1**
(43) Date of publication of application: **20.03.2024**
(21) Application number: 22807470.4
(22) Date of filing: 10.05.2022
(51) Int. Cl.: E06B 7/28

(54) **PARTITIONING MEMBER**

(30) Priority: 11.05.2021 JP 2021080594
(71) Applicant: International Frontier Technology Laboratory, Inc., Tokyo 105-0001 (JP)
(72) Inventor: KOMATSU, Nobuaki, Tokyo 105-0001 (JP)
(74) Representative: Ter Meer Steinmeister & Partner
(86) International application number: PCT/JP2022/019810
(87) International publication number: WO 2022/239770

(57) **Abstract**

An object of the present invention is to provide a technique capable of improving power generation efficiency using a temperature difference in a partitioning member and utilizing the generated electric power for various purposes. Accordingly, the partitioning member according to the present invention includes a thermally conductive member constituting part of the partitioning member, and a thermoelectric power generation unit in contact with a part of the thermally conductive member. In particular, the thermoelectric power generation unit has a heat reception surface and a heat radiation surface, and the heat reception surface and/or the heat radiation surface is in contact with the thermally conductive member, whereby a temperature difference within the partitioning member can be efficiently utilized. In addition, the thermoelectric power generation unit may include a plurality of the heat reception surfaces and/or a plurality of the heat radiation surfaces arranged in parallel on a plane.

## Description

### [Technical Field]

The present invention relates to a partitioning member including a fixture such as an aluminum sash, and more particularly, to a partitioning member including a thermoelectric power generation unit.

### [Background of the Invention]

Air-conditioning performance and airtightness performance of structures such as houses and buildings are increasing year by year. On the other hand, as the climate warms, the outside air temperature is increasing. In particular, in urban building construction, the temperature difference between indoor temperatures and the outside air temperature is trending towards an increase of several tens of degrees Celsius.

In addition, there can be large temperature differences not only in spaces partitioned by fixtures such as the windows or doors of a building, but also in spaces in which heat-generating units or the like are disposed, such as between the inside and outside of the vehicle body of an automobile, for instance.

While such temperature differences are also a cause of energy loss, on the contrary, effective utilization of such temperature differences as an energy source is also effective in realizing the sustainable energy cycle indicated in SDGs.

In order to reduce the risk of heat shock phenomena caused by the temperature difference between rooms, Patent Document 1 discloses a fixture including, in a door serving as a fixture, a Seebeck element, a first heat transfer space communicating between a first side of the Seebeck element and a first room (the space on one side), a second heat transfer space communicating between a second side of the Seebeck element and a second room (the space on the other side), an element seal member and a fixture seal member that block communication between the first heat transfer space and the second heat transfer space, and an LED lamp that is operated by electric power generated by the Seebeck element and that displays a temperature difference by lighting up.

In addition, Patent Document 1 discloses that a window serving as a fixture includes an electronic circuit that is operated by the electric power generated by the Seebeck element and transmits temperature difference information.

### [Citation List]

### [Patent Documents]

[Patent Document 1] Japanese Unexamined Patent Application Publication No. 2017-66667 A

### [Summary of Invention]

### [Technical Problem]

In Patent Document 1, a first heat transfer space and a second heat transfer space are employed in order to transfer heat to the Seebeck element, and the Seebeck element obtains the temperature difference between the two spaces through the respective heat transfer spaces. However, the thermal conductivity of the air is not necessarily high, and the power generation efficiency is limited by the thermal conductivity of the heat transfer space.

Accordingly, it is an object of the present invention is to provide a technique capable of improving power generation efficiency using the temperature difference in a partitioning member and utilizing the generated electric power for various purposes.

### [Means for Solving the Problems]

In order to solve the above problem, one representative partitioning member according to the present invention includes a thermally conductive member constituting part of the partitioning member; and a thermoelectric power generation unit in contact with a part of the thermally conductive member.

### [Advantageous Effects of Invention]

According to the present invention, it is possible to improve power generation efficiency using the temperature difference in a partitioning member and utilize the generated electric power for various purposes.

Problems, configurations, and effects other than those described above will become apparent from the following description of the embodiments.

### [Brief Description of Drawings]

[Fig. 1] FIG. 1 is a cross-sectional schematic view of the window panel of the aluminum sash of a sliding window according to a first embodiment.
[Fig. 2] FIG. 2 is a front perspective view of a thermoelectric power generation unit according to the first embodiment when the thermoelectric power generation unit is disposed around the window panel.
[Fig. 3] FIG. 3 is a cross-sectional schematic view of a case where an air passage is provided in the window panel according to the second embodiment.
[Fig. 4] FIG. 4 is a front perspective view in a case where an air circulation fan is provided in the air passage according to the third embodiment.

### [Description of Embodiment(s)]

Hereinafter, the embodiments of the present invention will be described with reference to the drawings. It should be noted that the present invention is not limited to these embodiments. In addition, in the description of the drawings, the same parts are denoted by the same reference numerals.

In the present disclosure, the partitioning member refers to a member that partitions the inside and outside of a structure, the space within a structure, or the space in which a heat-generating device or the like is disposed, or a member that partitions the inside and outside of an automobile body or the like, and includes windows, doors, and dividers as representative examples. Herein, windows and dividers encompass various forms thereof, such as those that can be opened and closed and those that cannot be opened and closed.

In addition, the thermally conductive member constituting a part of the partitioning member typically includes an aluminum member, an aluminum alloy member, a copper member, a copper alloy member, and other metal members, but is not limited to a metal material, and includes all members having thermal conductivity.

The thermoelectric power generation unit in the present disclosure typically includes a Seebeck element that generates electric power by a temperature difference. The Seebeck element according to the present disclosure generates electric power in accordance with a temperature difference between the heat reception surface and the heat radiation surface. The generated electric power may be stored in a power storage unit connected through an electric wire, or may be supplied to an electronic component including a control unit, an air circulation fan, a sensor, and the like.

Further, a booster may be provided between the thermoelectric power generation unit and the power storage unit as necessary.

The power storage unit in the present disclosure typically includes a capacitor and a secondary battery. The power storage unit may store electric power generated by a power generation unit other than the thermoelectric power generation unit. Further, the partitioning member of the present disclosure may be provided with a control unit for performing management such as charging and discharging of the power storage unit and controlling other electronic components.

### [First Embodiment]

### <Aluminum Sash of Sliding Window>

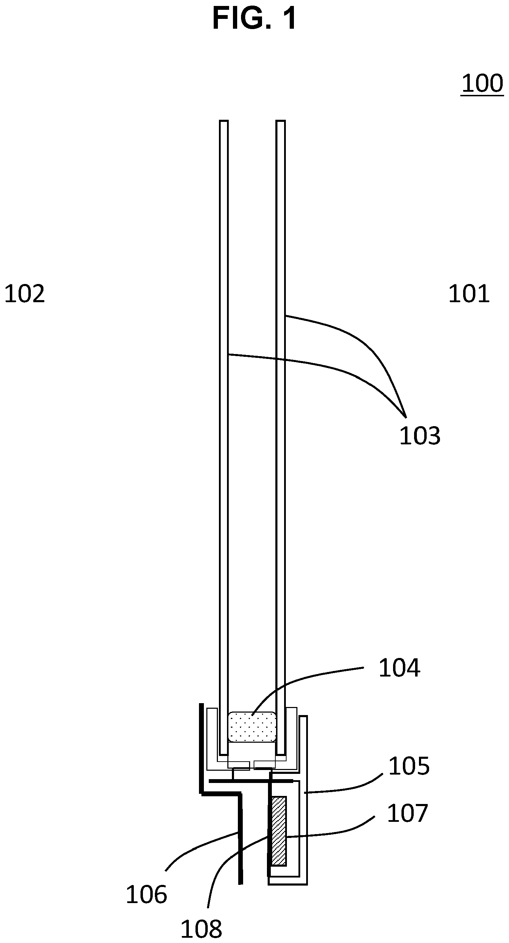

FIG. 1 is a cross-sectional schematic view of the window panel of the aluminum sash of a sliding window according to a first embodiment. In general, the aluminum sash 100 of the sliding is constituted by an inner window panel disposed on the indoor side 101 and an outer window panel disposed on the outdoor side 102, and a frame surrounding the outer window panel. The inner window panel and the outer window panel are suspended and installed in a frame. The cross-sectional view illustrated in FIG. 1 is a cross-section of the inner window panel or the outer window panel, and the cross-sectional configuration of the central portion is substantially the same for both the inner window panel and the outer window panel.

In FIG. 1, the glass portion of the window is composed of a double glass 103, and the space between the double glass 103 may be filled with argon gas. In addition, a Low-E film may be attached to the inner side of the double glass. A spacer 104 may be provided at an inner peripheral portion of the double glass, and a moisture absorbing material may be disposed.

On the outer periphery of the double glass 103, sashes 105 and 106 are provided as members constituting a part of the partitioning member. The sash 105 of the indoor side 101 of the partitioning member is formed of a thermally conductive member such as aluminum or a resin. Meanwhile, the sash 106 of the outdoor side 102 and the sash 108 of the central portion are formed of a thermally conductive member such as aluminum.

By forming the sash 105 on the indoor side 101 with resin, the heat insulating properties between the indoor side and the outdoor side can be enhanced. On the other hand, the sash of the outdoor side 102 is formed of a metal member such as aluminum in order to maintain the strength of the partitioning member and prevent deterioration of the member due to ultraviolet rays from the outside.

### <Arrangement of Thermoelectric Power Generation Element>

In the first embodiment, the Seebeck element 107 is placed in contact with the sash 108, which serves as a thermally conductive member constituting a part of the partitioning member. As a means for bringing the Seebeck element 107 into contact with the sash 108, various fixing methods can be used. In addition, a thermally conductive grease (thermal grease), which is a semi-solid material having excellent thermal conductivity, may be applied between the Seebeck element 107 and the sash 108.

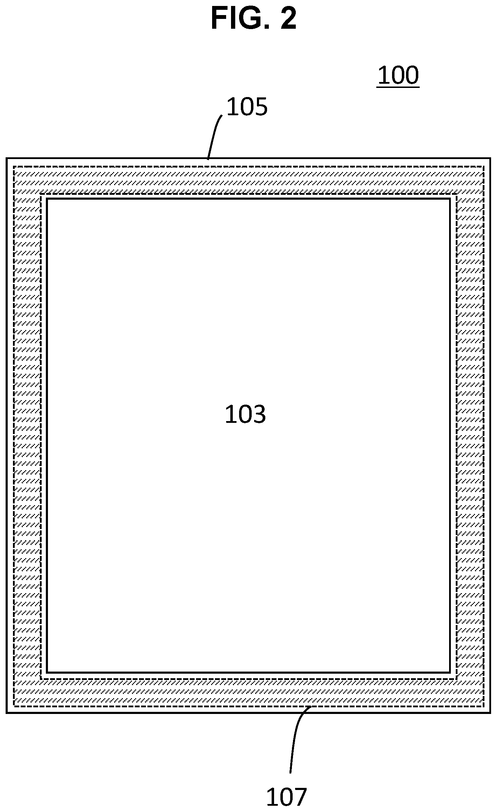

FIG. 2 is a front perspective view of the thermoelectric power generation unit (the Seebeck element 107) according to the first embodiment disposed around the window panel. As illustrated in FIG. 2, the Seebeck element may be arranged such that the heat reception surface or the heat radiation surface of the Seebeck element is substantially flush with the surface of the sash of the partitioning member. The method of disposing the Seebeck element 107 is arbitrary, and it is not necessary to dispose it all around entire window panel.

It should be noted that FIG. 2 illustrates the Seebeck element 107 because it is a perspective view, but in the first embodiment, the Seebeck element is disposed so as to be sandwiched between the sash 108 of the central portion and the sash 105 of the indoor side as illustrated in FIG. 1.

In the Seebeck element 107, lead wires provided for each element are connected in series or in parallel, and are connected to a power storage unit through an electric wire. A circuit is assembled so that the electric power stored in the power storage unit is supplied to electronic components as appropriate.

### <Operation and Effects>

In the case that the partitioning member is a window that partitions the inside and outside of a structure, the sash 106 of the outdoor side 102 and the sash 108 of the central portion are susceptible to the influence of the outside air temperature, and reach a high temperature of 50 degrees or more under direct sunlight in midsummer. In contrast, the temperature of the indoor side sash remains approximately 20 degrees due to air conditioning. Therefore, a temperature difference of several tens of degrees Celsius occurs in the partitioning member.

In addition, in the case of midwinter, even if the outside air temperature is around 0 degrees, the indoor space may be maintained at 20 degrees or more, and the temperature difference in the partitioning member is 20 degrees or more even in this case as well.

According to the first embodiment, when the outside air temperature is high, the Seebeck element 107 can efficiently receive the heat energy stored in the sash 106 thermally connected to the sash 108 by being in contact with the sash 108, which is a thermally conductive member.

In contrast, when the outside air temperature is lower than room temperature, the sash 106, which is thermally connected to the sash 108, can be used to efficiently radiate heat by being in contact with the sash 108, which is a thermally conductive member.

Further, since the Seebeck element 107 according to the first embodiment is sandwiched between the sash 108 of the central portion and the sash 105 of the indoor side, it cannot be seen from either inside the room or from outside the room, and does not impair the appearance of the window.

### [Second Embodiment]

### <Air Passage>

The second embodiment differs from the first embodiment in that the Seebeck element 107 has an air passage 120 on the side not contacting the thermally conductive member.

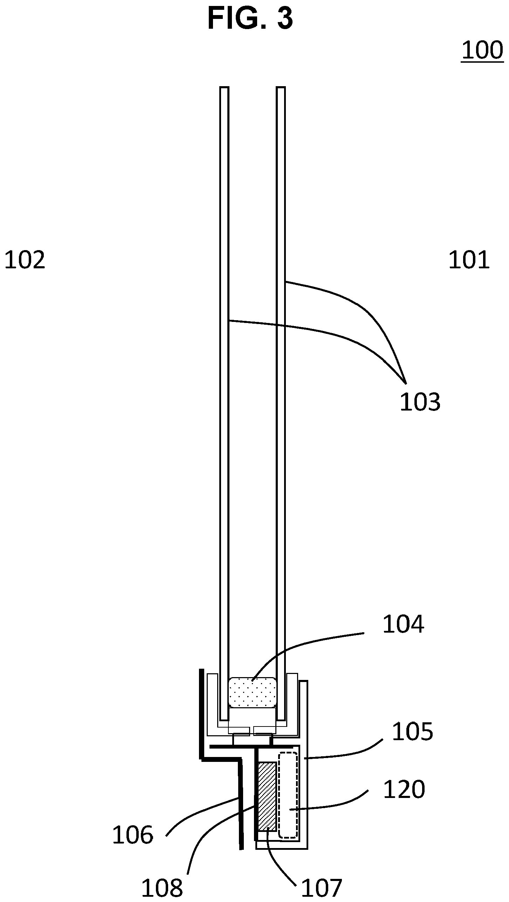

FIG. 3 is a cross-sectional schematic view of a case where an air passage is provided in the window panel according to the second embodiment. In the following description, the same or equivalent components as those of the first embodiment described above are denoted using the same reference numerals, and the description thereof will be simplified or omitted.

In the second embodiment, as illustrated in FIG. 3, an air passage 120 is provided on the side where the Seebeck element 107 does not contact the thermally conductive member. Although it is desirable to provide the air passage including the range in which the Seebeck element 107 is disposed in the window panel, it is not necessary to provide the air passage corresponding to the region in which the Seebeck element 107 is disposed.

### <Operation and Effects>

By providing the air passage 120 on the side where the Seebeck element 107 does not come into contact with the thermally conductive member (hereinafter, referred to as the "back surface"), it is possible to efficiently transmit the temperature difference around the Seebeck element 107 on the back surface of the Seebeck element 107 as well.

That is, when the side where the Seebeck element 107 is in contact with the thermally conductive member is the heat reception surface, heat can be effectively radiated in the back surface of the Seebeck element 107. In contrast, in a case where the side where the Seebeck element 107 is in contact with the thermally conductive member is the heat radiation surface, the air flows across the back surface of the Seebeck element 107 such that the heat can be effectively received.

### [Third Embodiment]

### <Air inlet, Air outlet, Air Circulation Fan>

The third embodiment differs from the second embodiment in that the air passage 120 of the second embodiment includes an air inlet 121, an air outlet 122, and an air circulation fan 125.

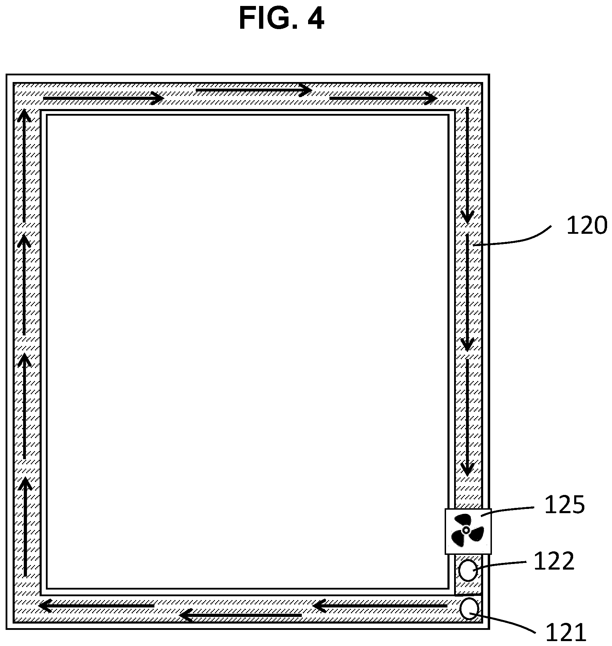

FIG. 4 is a front perspective view of a case where an air inlet 121, an air outlet 122, and an air circulation fan 125 are provided in the window panel according to the third embodiment. In the following description, the same or equivalent components as those of the first embodiment and the second embodiment described above are denoted by the same reference numerals, and the description thereof will be simplified or omitted.

In the third embodiment, as illustrated in FIG. 4, the sash 105 of the window panel is provided with an air inlet 121 and an air outlet 122 which communicate with the air passage 120, and also an air circulation fan 125 for circulating air inside the air passage 120 is installed. The air circulation fan 125 may be driven by the electric power generated by the thermoelectric power generation unit, or may be driven by a dry battery or other self-supporting power source (for example, a photovoltaic power source utilizing the light from a window).

It should be noted that the arrangement and size of the air inlet 121 and the air outlet 122, and the number of installations, can be arbitrarily determined, and the arrangement illustrated in FIG. 4 is not necessarily required. In addition, the air circulation fan 125 is not necessarily an essential configuration.

### <Operation and Effects>

When the air inlet 121 and the air outlet 122 are provided as illustrated in FIG. 4 and the air circulation fan 125 for circulating air is installed inside the air passage 120, for example, by driving the air circulation fan 125, the air in the air passage 120 is discharged from the air outlet 122, and accordingly, the indoor air is sucked in from the air inlet 121. Then, air circulation is generated inside the air passage 120 as indicated by the arrow in the air passage 120 of FIG. 4. As a result, air is forcibly circulated across the back surface of the Seebeck element 107. Accordingly, the Seebeck element 107 can effectively receive heat.

### [Application Example of Thermoelectric Power Generation Unit]

Hereinafter, an application example using the electric power generated by the thermoelectric power generation unit according to the first to third embodiments will be described.

### <Ventilation Aperture>

If the partitioning member is provided with a ventilation aperture capable of electric braking and this is driven by using the electric power accumulated in the power storage unit of the present disclosure, ventilation through the partitioning member can be performed in an opportune manner without constructing wires for each partitioning member for supplying electric power.

As a method of supplying power to the partitioning member without wiring for the power supply, although a method can be considered in which a dry battery or the like is provided in the partitioning member and used as the power source for driving, when the partitioning member is installed in high places, battery replacement operations become burdensome. However, by utilizing the electric power from the thermoelectric power generation unit as the self-sustaining power supply of the present disclosure, it becomes possible to solve such problems.

### <IoT sensor>

If various IoT sensors that can be installed in the partitioning member are installed in place of the ventilation aperture described above, or in combination with the ventilation aperture, by performing driving using the electric power accumulated in the power storage unit according to the present disclosure, the sensor detection data can be transmitted wirelessly or the like. Here, an IoT sensor refers to a sensor that connects a sensor to a network to collect and manage data.

Specifically, optical sensors, image sensors, pressure sensors, temperature sensors, humidity sensors, acceleration sensors, and the like are representative examples.

By utilizing the collected data of these IoT sensors, the status of the partitioning member (opening and closing of doors and windows, passage of a person, and the like) can be monitored in real time. In addition, by leveraging data such as the room temperature, it is possible to use it for predictive monitoring of accidents and disasters, as well as security monitoring.

### <Window Dimmer Control>

Further, if a liquid crystal filter is installed on the glass surface of the window and driven using the power stored in the power storage unit of the present disclosure, it becomes possible to opportunely perform dimming control even for windows installed in high places.

Next, a description will be given of a deployment example of application locations of the thermoelectric power generation units according to the first to third embodiments described above.

### <Data Center, Server Room>

The partitioning member of the present invention can be applied to various places where temperature differences occurs. For example, if the thermoelectric power generation unit according to the present disclosure is installed as a partitioning member together with a metal sash in a heat dissipation device of a data center or a server where large amounts of heat are generated, it is possible to obtain a large amount of thermoelectric energy.

### <Internal Combustion Engine>

Internal combustion engines installed in factories, transportation vehicles, or the like generate large amounts of heat. Accordingly, by installing the partitioning member of the present invention in the vicinity thereof, it is possible to obtain a large amount of thermoelectric energy.

### <Automobile>

Even in electric vehicles (EVs), heat generating parts such as the motor, and the metallic hood portion are likely to have a thermal difference with respect to the outside. Accordingly, by installing the partitioning member of the present invention in the vicinity thereof, it is possible to obtain a large amount of thermoelectric energy.

Although the embodiments of the present invention have been described above, the present invention is not limited to the above-described embodiments, and various modifications can be made without departing from the gist of the present invention.

### [Reference Signs List]

- 100: Aluminum sash
- 103: Double glass
- 105, 106, 108: Sash
- 107: Seebeck element
- 120: Air passage
- 121: Air inlet
- 122: Air outlet
- 125: Air circulation fan

## Claims

1. A partitioning member comprising:
a thermally conductive member constituting part of the partitioning member; and
a thermoelectric power generation unit in contact with a part of the thermally conductive member.

2. The partitioning member according to claim 1, wherein:
the thermoelectric power generation unit has a heat reception surface and a heat radiation surface; and
at least one of the heat reception surface or the heat radiation surface is in contact with the thermally conductive member.

3. The partitioning member according to claim 2, wherein:
a plurality of the heat reception surfaces or a plurality of the heat radiation surfaces of the thermoelectric power generation unit are arranged in parallel on a plane.

4. The partitioning member according to claim 2 or 3, wherein:
the thermally conductive member is in contact with an air passage on a surface that is not in contact with the heat reception surface or the heat radiation surface; and
the air passage is provided with an air circulation fan.

5. The partitioning member according to any one of claims 2 to 4, wherein:
the partitioning member has a power storage unit and a control unit.

6. The partitioning member according to any one of claims 2 to 5, wherein:
the partitioning member has an air circulation fan driven by electric power generated by the thermoelectric power generation unit.

7. A partitioning member according to any one of claims 2 to 5, wherein:
the partitioning member has a ventilation aperture driven by electric power generated by the thermoelectric power generation unit.

8. The partitioning member according to any one of claims 2 to 5, wherein:
the partitioning member has a sensor driven by electric power generated by the thermoelectric power generation unit.
